# EUROPEAN PATENT APPLICATION

(11) **EP 4 848 528 A1**
(43) Date of publication of application: **02.12.2026**
(21) Application number: 25866316.0
(22) Date of filing: 07.07.2025
(51) Int. Cl.: H02J 7/00, H01M 10/42, H01M 50/569, G01R 31/3835, G01R 19/165

(54) **BATTERY SYSTEM AND SWITCH CONTROL METHOD THEREFOR**

(30) Priority: 10.09.2024 KR 20240123106
(71) Applicant: LG Energy Solution, Ltd., Seoul 07335 (KR)
(72) Inventor: KIM, Sungwon, Daejeon 34122 (KR); JEONG, Dooho, Daejeon 34122 (KR)
(74) Representative: Goddar, Heinz J.
(86) International application number: PCT/KR2025/009756
(87) International publication number: WO 2026/059060

(57) **Abstract**

A battery system according to an embodiment of the present disclosure comprises: a first battery; a second battery connected in parallel with the first battery; a DC-DC converter electrically connected between the first battery and the second battery so as to convert output power of at least one of the first battery and the second battery; a switch connected in parallel with the DC-DC converter so as to be selectively opened or closed; a voltage sensor for measuring voltages of the first battery and the second battery; and a battery management device operatively connected to the switch and the voltage sensor, wherein the battery management device may acquire, from the voltage sensor, a first voltage of the first battery and a second voltage of the second battery, and control the switch on the basis of the first voltage and the second voltage.

## Description

### Technical Field

This application claims the benefit of Korean Patent Application No. 10-2024-0123106, filed on September 10, 2024, in the Korean Intellectual Property Office, the disclosure of which is incorporated herein by reference in its entirety.

Example embodiments disclosed in the present document relate to a battery system and a method of controlling a switch thereof.

### Background Art

In recent years, there has been active research and development in the field of secondary batteries. Here, secondary batteries refer to batteries capable of being charged and discharged, including conventional Ni/Cd batteries, Ni/MH batteries, as well as recent lithium-ion batteries, and the like. Lithium-ion batteries of secondary batteries have an advantage of having greater energy density more than Ni/Cd batteries, Ni/MH batteries, and the like. In addition, since lithium-ion batteries can be manufactured in a compact and lightweight form, lithium-ion batteries are used as a power source of a mobile device and, in recent years, their usage range has been broadened to a power source of an electric vehicle, gaining attention as a next-generation energy storage device.

As such a usage range of secondary batteries has been expanded, a technology related to a management system for using and managing secondary batteries more efficiently is increasingly significant. States and operations of secondary batteries may be controlled by a battery management system (BMS). The BMS may be included in a single device with a battery.

Meanwhile, in a case of a battery system in which a plurality of batteries are connected in parallel, a DC-DC converter is necessary at a point at which the batteries are connected in parallel since a voltage difference between the batteries may occur. In particular, a battery pack composed of a dual battery system including two batteries made of different components has been developed recently. Since the two batteries in such a battery pack are connected in parallel, the DC-DC converter is also necessarily disposed in the battery system.

In relation to this, the DC-DC converter uses more battery capacity since power loss occurs in a process of performing power conversion. In particular, the power conversion by the DC-DC converter is inevitable when a voltage difference between batteries connected to one another in parallel is beyond a certain range. However, performing the power conversion even when the voltage difference is within the certain range may cause unnecessary power loss.

### Detailed Description of the Invention

### Technical Goals

According to an example embodiment of the present disclosure, a battery system capable of controlling, based on voltages of two batteries connected to one another in parallel, a switch connected to a DC-DC converter in parallel between the two batteries, and a method of controlling the switch thereof may be provided.

A technical task to be achieved by an example embodiment of the present disclosure is not limited to the technical tasks described above, and other technical tasks may be derived from example embodiments described below.

### Technical solutions

According to an example embodiment of the present disclosure, a battery system may include a first battery, a second battery connected to the first battery in parallel, a DC-DC converter electrically connected between the first battery and the second battery and converting output power of at least one of the first battery and the second battery, a switch connected to the DC-DC converter in parallel and selectively opened and closed, a voltage sensor for measuring voltages of the first battery and the second battery, and a battery management apparatus operatively connected to the switch and the voltage sensor. The battery management apparatus may acquire a first voltage of the first battery and a second voltage of the second battery from the voltage sensor and control the switch based on the first voltage and the second voltage.

According to an example embodiment of the present disclosure, for the battery system, the battery management apparatus may short-circuit the switch when a voltage difference between the first voltage and the second voltage is less than or equal to a threshold value.

According to an example embodiment of the present disclosure, for the battery system, the battery management apparatus may open the switch when the voltage difference between the first voltage and the second voltage is greater than the threshold value.

According to an example embodiment of the present disclosure, for the battery system, the DC-DC converter may be a 4-switch buck boost converter.

According to an example embodiment of the present disclosure, for the battery system, the DC-DC converter may include a first switching element, a second switching element, a third switching element, a fourth switching element, and an inductor. The first switching element may be configured to selectively connect a positive electrode of the first battery to the second switching element and the inductor. The second switching element may be configured to selectively connect the first switching element and the inductor to a negative electrode of the first battery. The third switching element may be configured to selectively connect the fourth switching element and the inductor to a negative electrode of the second battery. The fourth switching element may be configured to selectively connect a positive electrode of the second battery to the third switching element and the inductor.

According to an example embodiment of the present disclosure, for the battery system, the first battery and the second battery may be battery cells, battery modules, battery packs, or battery racks.

According to an example embodiment of the present disclosure, for the battery system, the first battery and the second battery may be made of different components and have different chemical properties.

According to an example embodiment of the present disclosure, a method of controlling a switch, performed by a battery system, may include acquiring a first voltage of a first battery and a second voltage of a second battery connected to the first battery in parallel and controlling, based on the first voltage and the second voltage, a switch connected to a DC-DC converter in parallel between the first battery and the second battery and selectively opened and closed. The DC-DC converter may be electrically connected between the first battery and the second battery and convert output power of at least one of the first battery and the second battery.

According to an example embodiment of the present disclosure, for the method of controlling a switch, performed by a battery system, the controlling of the switch may include closing the switch when a voltage difference between the first voltage and the second voltage is less than or equal to a threshold value.

According to an example embodiment of the present disclosure, for the method of controlling a switch, performed by a battery system, the controlling of the switch may include opening the switch when the voltage difference between the first voltage and the second voltage is greater than the threshold value.

According to an example embodiment of the present disclosure, for the method of controlling a switch, performed by a battery system, the DC-DC converter may be a 4-switch buck boost converter.

According to an example embodiment of the present disclosure, for the method of controlling a switch, performed by a battery system, the DC-DC converter may include a first switching element, a second switching element, a third switching element, a fourth switching element, and an inductor. The first switching element may be configured to selectively connect a positive electrode of the first battery to the second switching element and the inductor. The second switching element may be configured to selectively connect the first switching element and the inductor to a negative electrode of the first battery. The third switching element may be configured to selectively connect the fourth switching element and the inductor to a negative electrode of the second battery. The fourth switching element may be configured to selectively connect a positive electrode of the second battery to the third switching element and the inductor.

According to an example embodiment of the present disclosure, for the method of controlling a switch, performed by a battery system, the first battery and the second battery may be battery cells, battery modules, battery packs, or battery racks.

According to an example embodiment of the present disclosure, for the method of controlling a switch, performed by a battery system, the first battery and the second battery may be made of different components and have different chemical properties.

### Effects of the Invention

According to example embodiments disclosed in this document, it is possible to minimize power loss by controlling, based on voltages of two batteries connected to one another in parallel, a switch connected to a DC-DC converter in parallel between the two batteries.

The effects of the invention are not limited to those described above, and other effects not explicitly described may be clearly understood by those skilled in the art from the scope of the claims.

### Brief Description of Drawings

FIG. 1 is a block diagram of a battery system according to an example embodiment of the present disclosure.
FIG. 2 is a circuit diagram of a battery system according to an example embodiment of the present disclosure.
FIG. 3A is a diagram for describing an example in which a battery system closes a switch according to an example embodiment of the present disclosure.
FIG. 3B is a diagram for describing an example in which a battery system opens a switch according to an example embodiment of the present disclosure.
FIG. 4 is a circuit diagram of a battery system according to an example embodiment of the present disclosure.
FIG. 5 is an operation flowchart of a battery system according to an example embodiment of the present disclosure.
FIG. 6 is an operation flowchart of a battery system according to an example embodiment of the present disclosure.

### Mode for Carrying Out the Invention

For describing example embodiments, descriptions of technical contents that are well known in the art to which the present disclosure belongs and are not directly related to the present disclosure will be omitted. This is to more clearly communicate without obscuring the subject matter of the present disclosure by omitting unnecessary descriptions.

For the same reason, in the accompanying drawings, some components are exaggerated, omitted, or schematically illustrated. In addition, the size of each component does not fully reflect the actual size. The same or corresponding components in each drawing are given the same reference numerals.

Advantages and features of the present disclosure and methods of achieving them will be apparent from the following example embodiments that will be described in more detail with reference to the accompanying drawings. It should be noted, however, that the present disclosure is not limited to the following example embodiments, and may be implemented in various forms. Accordingly, the example embodiments are provided only to disclose the present disclosure and let those skilled in the art know the category of the present disclosure, and the present disclosure is only defined by the category of claims. The same reference numerals or the same reference designators denote the same components throughout the specification.

Here, it will be understood that each block of the flowchart illustrations and combinations of flowchart illustrations may be performed by computer program instructions. Since these computer program instructions may be mounted on a processor of a general-purpose computer, special-purpose computer, or other programmable data processing equipment, those instructions executed through the computer or the processor of other programmable data processing equipment may create a means to perform the functions described in flowchart block(s). These computer program instructions may be stored in a computer usable or computer readable memory that can be directed to a computer or other programmable data processing equipment to implement functionality in a particular manner, and thus computer program instructions stored in the computer usable or computer readable memory can produce an article of manufacture containing instruction means for performing the functions described in the flowchart block(s). Computer program instructions may also be mounted on a computer or other programmable data processing equipment, such that a series of operating steps may be performed on the computer or other programmable data processing equipment to create a computer-implemented process to create a computer or other programmable data. Instructions for performing the processing equipment may also provide steps for performing the functions described in the flowchart block(s).

In addition, each block may represent a portion of a module, segment, or code that includes one or more executable instructions for executing a specified logical function(s). It should also be noted that in some alternative implementations, the functions noted in the blocks may occur out of order. For example, the two blocks shown in succession may in fact be executed substantially concurrently, or the blocks may sometimes be executed in the reverse order, depending on the corresponding function.

In addition, the term "unit," refers to software or hardware components, such as FPGA or ASIC. "Unit" performs some roles. However, "unit" is not limited to software or hardware. "Unit" may be configured to be in an addressable storage medium or to restart one or more processors. Accordingly, for example, "unit" includes components such as software components, object-oriented software components, class components, and task components, and includes processes, functions, attributes, procedures, subroutines, segments of program code, drivers, firmware, microcode, circuitry, data, databases, data structures, tables, arrays, and variables. Functions provided within components and "units" may be combined into a fewer number of components and "units" or may be further separated into additional components and "units". Furthermore, the components and "units" may be implemented to restart one or more CPUs within a device or a secure multimedia card.

The expression "at least one of A, B, and C" described in this specification may indicate the following meaning including: A alone; B alone; C alone; both A and B together; both A and C together; both B and C together; or all three of A, B, and C together.

In the present disclosure, a "terminal" may be implemented as a computer or a portable terminal capable of accessing a server or another terminal through a network. Here, the computer may include, for example, a notebook equipped with a web browser, a desktop computer, and a laptop computer. The portable terminal may be a wireless communication device ensuring a portability and a mobility, and include any type of handheld wireless communication device, for example, a tablet PC, a smartphone, a communication-based terminal such as international mobile telecommunication (IMT), code division multiple access (CDMA), W-code division multiple access (W-CDMA), and long term evolution (LTE).

In the following description, example embodiments of the present disclosure will be described in detail with reference to the drawings so that those skilled in the art can easily carry out the present disclosure. However, the present disclosure may be embodied in many different forms and is not limited to the embodiments described herein.

Hereinafter, example embodiments of the present disclosure will be described in detail with reference to the accompanying drawings.

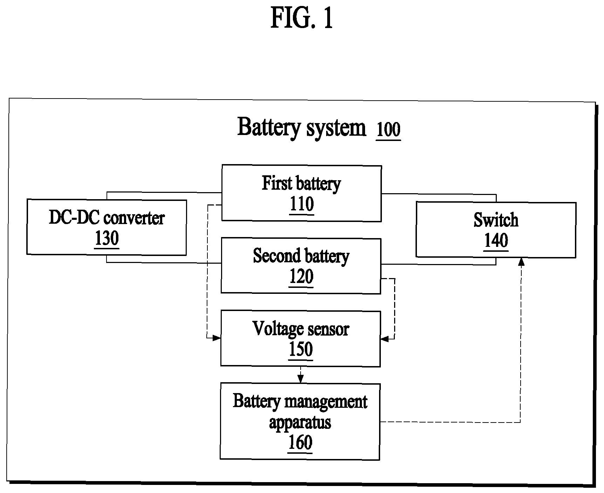

FIG. 1 is a block diagram of a battery system 100 according to an example embodiment of the present disclosure.

The battery system 100 that will be described hereinafter may be a battery module, a battery pack, a battery rack, or an energy storage system (ESS), including a first battery 110 and a second battery 120, which are unit batteries. Here, the unit batteries may refer to subordinate batteries of the battery system 100. For example, when the battery system 100 are battery modules, the first battery 110 and the second battery 120 may be battery cells. For another example, when the battery system 100 is a battery pack or a battery rack, the first battery 110 and the second battery 120 may be battery cells or battery modules. In addition, for another example, when the battery system 100 is an ESS, the first battery 110 and the second battery 120 may be battery packs or battery racks.

Referring to FIG. 1, the battery system 100 may include the first battery 110, the second battery 120, a DC-DC converter 130, a switch 140, a voltage sensor 150, and a battery management apparatus 160.

According to an example embodiment, the first battery 110 and the second battery 120 may be connected to one another in parallel. Accordingly, positive electrodes and negative electrodes of the first battery 110 and the second battery 120 may be electrically connected to a positive electrode output terminal (not illustrated) and a negative electrode output terminal (not illustrated) of the battery system 100, respectively.

According to an example embodiment, the first battery 110 and the second battery 120 may be made of different components and have different chemical properties. For example, the first battery 110 and the second battery 120 may be a lithium ferrophosphate (LFP) battery and a nickel cobalt manganese (NCM) battery, respectively.

Meanwhile, it is illustrated in FIG. 1 that only two batteries 110, 120 are included in the battery system 100, but this is not limited thereto. The battery system 100 may include three or more batteries connected to one another in parallel.

According to an example embodiment, the DC-DC converter 130 may be electrically connected between the first battery 110 and the second battery 120 and convert output power of at least one of the first battery 110 and the second battery 120. The DC-DC converter 130 may convert power provided from at least one of the first battery 110 and the second battery 120 into power based on a predetermined voltage and a predetermined current. For example, when an output voltage of the first battery 110 is higher than an output voltage of the second battery 120, the DC-DC converter 130 may boost the output voltage of the first battery 110 to be equal to the output voltage of the second battery 120.

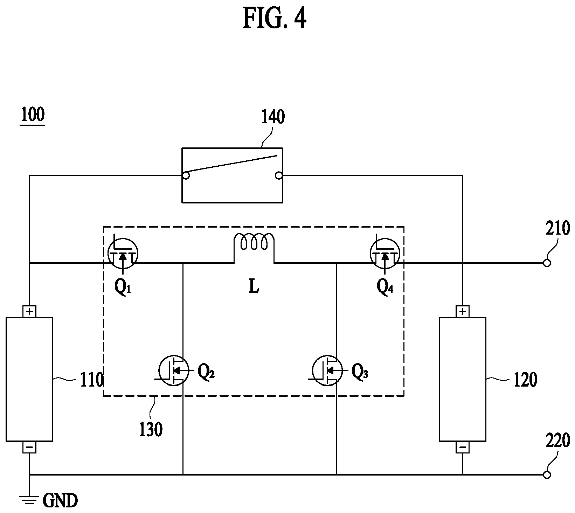

According to an example embodiment, the DC-DC converter 130 may be a 4-switch buck boost converter. A circuit diagram in a case in which the DC-DC converter 130 is implemented as a 4-switch buck boost converter may be described in detail through FIG. 4 described below.

According to an example embodiment, the switch 140 may be connected to the DC-DC converter 130 in parallel. The switch 140 may be implemented as a relay selectively opened and closed. According to an example embodiment, a maximum switching voltage of the switch 140 may be equal to or greater than rated voltages of the first battery 110 and the second battery 120.

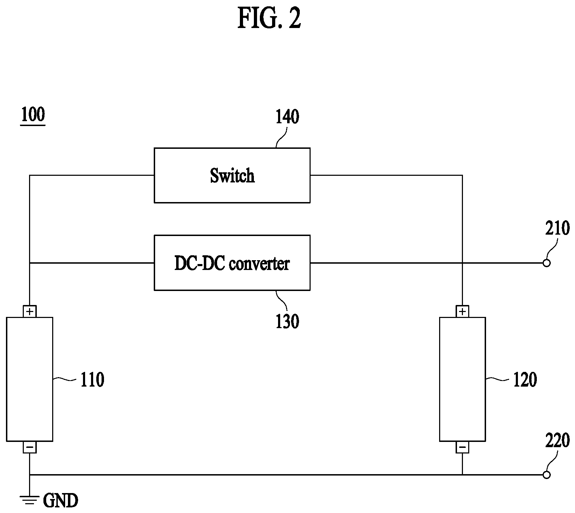

Hereinafter, referring to FIG. 2, a connection structure of the first battery 110, the second battery 120, the DC-DC converter 130, and the switch 140 included in the battery system 100 may be described.

FIG. 2 is a circuit diagram of the battery system 100 according to an example embodiment of the present disclosure.

Referring to FIG. 2, the first battery 110 and the second battery 120 may be connected to one another in parallel based on a positive electrode output terminal 210 and a negative electrode output terminal 220 of the battery system 100. According to an example embodiment, the positive electrode output terminal 210 and the negative electrode output terminal 220 may be connected to an external load to supply output power of the battery system 100 to the external load.

According to an example embodiment, the DC-DC converter 130 may be electrically connected between the first battery 110 and the second battery 120, and the switch 140 may be connected to the DC-DC converter 130 in parallel. Accordingly, when the switch 140 is closed, a current between the first battery 110 and the second battery 120 flows through the switch 140, not through the DC-DC converter 130, and thus power conversion by the DC-DC converter 130 may not be performed. In addition, when the switch 140 is opened, the current between the first battery 110 and the second battery 120 flows through the DC-DC converter 130, and thus the power conversion by the DC-DC converter 130 may be performed.

Referring back to FIG. 1, the voltage sensor 150 may measure voltages of the first battery 110 and the second battery 120. The voltage sensor 150 may acquire voltage data by measuring the voltages of the first battery 110 and the second battery 120. The voltage sensor 150 may provide the acquired voltage data to the battery management apparatus 160. According to an example embodiment, the voltage sensor 150 may be implemented as a configuration included in the battery management apparatus 160.

According to an example embodiment, the battery management apparatus 160 may be implemented as a computer or a similar apparatus (for example, a battery management system (BMS)) according to hardware, software, or a combination thereof. The battery management apparatus 160 may be implemented in a form of an electronic circuit in terms of hardware that processes an electrical signal and performs a control function, and implemented in a form of a program in terms of software that drives the hardware battery management apparatus 160. According to an example embodiment, the battery management apparatus 160 may be operatively connected to components (for example, the switch 140 and/or the voltage sensor 150) included in the battery system 100 and control the connected components.

According to an example embodiment, the battery management apparatus 160 may acquire a first voltage of the first battery 110 and a second voltage of the second battery 120 from the voltage sensor 150. The battery management apparatus 160 may control the switch 140 based on the acquired first voltage and second voltage.

Meanwhile, unless otherwise specified in the following description, an operation of the battery system 100 may be understood as being performed by control of the battery management apparatus 160.

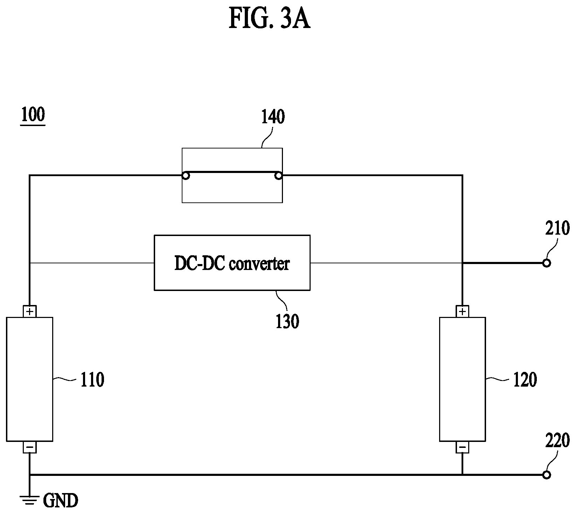

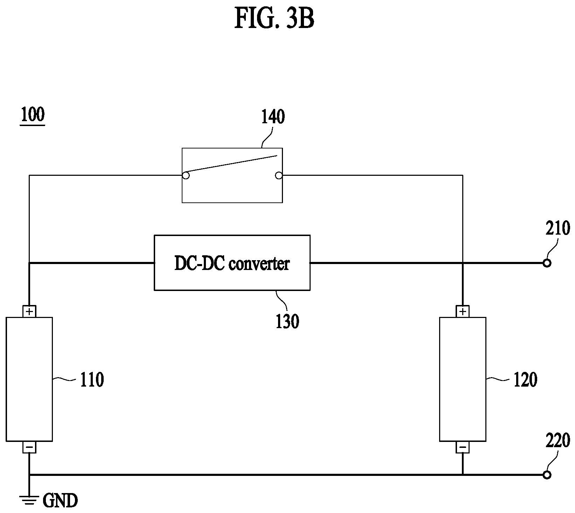

Hereinafter, referring to FIG. 3A and FIG. 3B, an operation of the battery system 100 controlling the switch 140 based on voltages of the first battery 110 and the second battery 120 will be described.

FIG. 3A is a diagram for describing an example in which the battery system 100 closes the switch 140 according to an example embodiment of the present disclosure.

Referring to FIG. 3A, the battery system 100 may close the switch 140 when a voltage difference between a first voltage of the first battery 110 and a second voltage of the second battery 120 is less than or equal to a threshold value. In this case, since a current between the first battery 110 and the second battery 120 flows through the switch 140, not through the DC-DC converter 130, power conversion by the DC-DC converter 130 may not be performed.

FIG. 3B is a diagram for describing an example in which the battery system 100 opens the switch 140 according to an example embodiment of the present disclosure.

Referring to FIG. 3B, the battery system 100 may open the switch 140 when a voltage difference between a first voltage of the first battery 110 and a second voltage of the second battery 120 is greater than a threshold value. In this case, since a current between the first battery 110 and the second battery 120 flows through the DC-DC converter 130, power conversion by the DC-DC converter 130 may be performed.

FIG. 4 is a circuit diagram of the battery system 100 according to an example embodiment of the present disclosure.

Referring to FIG. 4, the DC-DC converter 130 may be implemented as a 4-switch buck boost converter including a first switching element Q₁, a second switching element Q₂, a third switching element Q₃, a fourth switching element Q₄, and an inductor L.

According to an example embodiment, the first switching element Q₁ may be configured to selectively connect a positive electrode of the first battery 110 to the second switching element Q₂ and the inductor L.

According to an example embodiment, the second switching element Q₂ may be configured to selectively connect the first switching element Q₁ and the inductor L to a negative electrode of the first battery 110.

According to an example embodiment, the third switching element Q₃ may be configured to selectively connect the fourth switching element Q₄ and the inductor L to a negative electrode of the second battery 120.

According to an example embodiment, the fourth switching element Q₄ may be configured to selectively connect a positive electrode of the second battery 120 to the third switching element Q₃ and the inductor L.

According to an example embodiment, the battery system 100 may control the DC-DC converter 130 implemented as the 4-switch buck boost converter to be operated in a buck mode and a boost mode.

In the buck mode of stepping down and outputting an output voltage of the first battery 110, the first switching element Q₁ and the second switching element Q₂ of the DC-DC converter 130 may be periodically switched, respectively, to alternately enter the open state and the closed state. For example, the first switching element Q₁ and the second switching element Q₂ may be switched complementarily. Accordingly, the second switching element Q₂ may be in a closed state when the first switching element Q₁ is in an open state, and the second switching element Q₂ may be in the open state when the first switching element Q₁ is in the closed state. Here, the third switching element Q₃ may be in the open state consistently, and the fourth switching element Q₄ may be in the closed state consistently.

In the boost mode of boosting and outputting the output voltage of the first battery 110, the third switching element Q₃ and the fourth switching element Q₄ of the DC-DC converter 130 may be periodically switched, respectively, to alternately enter the open state or the closed state. For example, the third switching element Q₃ and the fourth switching element Q₄ are switched complementarily. Accordingly, the fourth switching element Q₄ may be in the closed state when the third switching element Q₃ is in the open state, and the fourth switching element Q₄ may be in the open state when the third switching element Q₃ is in the closed state. Here, the first switching element Q1 may be in the closed state consistently, and the second switching element Q2 may be in the open state consistently.

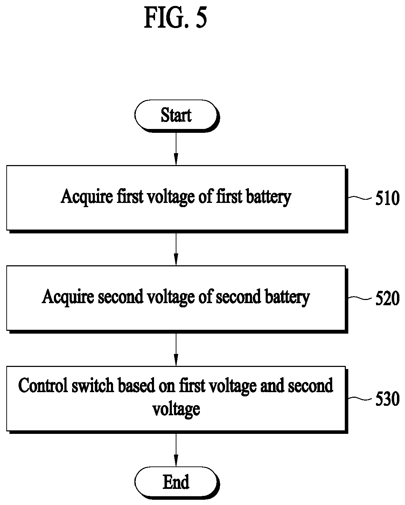

FIG. 5 is an operation flowchart of a battery system according to an example embodiment of the present disclosure. Since an operation method of FIG. 5 may be performed by the battery system 100 of FIG. 1, redundant descriptions may be omitted and may be described by considering the Fig. 5 method in the context of the components of FIG. 1.

An example embodiment illustrated in FIG. 5 is merely an example. An order of operations according to various example embodiments of the present disclosure may be different from that illustrated in FIG. 5. Some operations illustrated in FIG. 5 may be omitted, an order of operations may be changed, or operations may be combined.

Referring to FIG. 5, in operation 510, the battery system 100 may acquire a first voltage of the first battery 110. According to an example embodiment, the battery system 100 may acquire voltage data of the first battery 110 by using the voltage sensor 150 and measuring the first voltage of the first battery 110.

In operation 520, the battery system 100 may acquire a second voltage of the second battery 120. According to an example embodiment, the battery system 100 may acquire voltage data of the second battery 120 by using the voltage sensor 150 and measuring a second voltage of the second battery 120.

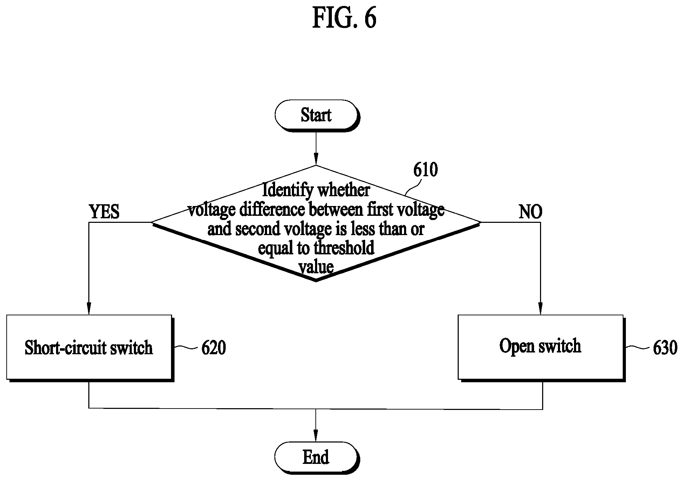

In operation 530, the battery system 100 may control the switch 140 based on the first voltage acquired in operation 510 and the second voltage acquired in operation 520. Operation 530 in which the battery system 100 controls the switch 140 may be described in detail through FIG. 6 described below.

FIG. 6 is an operation flowchart of a battery system according to an example embodiment of the present disclosure. Since an operation method of FIG. 6 may be performed by the battery system 100 of FIG. 1, redundant descriptions may be omitted and may be described by considering the Fig. 6 method in the context of the components of FIG. 1.

An example embodiment illustrated in FIG. 6 is merely an example. An order of operations according to various example embodiments of the present disclosure may be different from that illustrated in FIG. 6. Some operations illustrated in FIG. 6 may be omitted, an order of operations may be changed, or operations may be combined.

Referring to FIG. 6, in operation 610, the battery system 100 may identify whether a voltage difference between a first voltage of the first battery 110 and a second voltage of the second battery 120 is less than or equal to a threshold value.

When it is identified in operation 610 that the voltage difference between the first voltage and the second voltage is less than or equal to the threshold value ('YES'), in operation 620, the battery system 100 may close the switch 140. In this case, since a current between the first battery 110 and the second battery 120 flows through the switch 140, not through the DC-DC converter 130, power conversion by the DC-DC converter 130 may not be performed.

When it is identified in operation 610 that the voltage difference between the first voltage and the second voltage is greater than the threshold value ('No'), in operation 630, the battery system 100 may open the switch 140. In this case, since the current between the first battery 110 and the second battery 120 flows through the DC-DC converter 130, the power conversion by the DC-DC converter 130 may be performed.

The present example embodiments may be represented by functional blocks and various processing steps. These functional blocks may be implemented by various numbers of hardware and/or software configurations that execute specific functions. For example, the present example embodiments may adopt integrated circuit configurations such as a memory, a processor, a logic circuit, and a look-up table that may execute various functions by control of one or more microprocessors or other control devices. Similarly to that components may be executed by software programming or software components, the present example embodiments may be implemented by programming or scripting languages such as C, C++, Java, and assembler language, including various algorithms implemented by combinations of data structures, processes, routines, or of other programming configurations. Functional aspects may be implemented by algorithms executed by one or more processors. In addition, the present example embodiments may adopt the related art for electronic environment setting, signal processing, and/or data processing. The terms "mechanism", "component", "means", and "configuration" may be widely used and are not limited to mechanical and physical elements. These terms may include meaning of a series of routines of software in association with the processor.

The above-described example embodiments are merely examples, and other example embodiments may be implemented within the scope of the following claims.

## Claims

1. A battery system comprising:
a first battery;
a second battery configured to be connected to the first battery in parallel;
a DC-DC converter configured to be electrically connected between the first battery and the second battery to convert output power of at least one of the first battery and the second battery;
a switch configured to be connected to the DC-DC converter in parallel and selectively opened and closed;
a voltage sensor for measuring voltages of the first battery and the second battery; and
a battery management apparatus configured to be operatively connected to the switch and the voltage sensor,
wherein the battery management apparatus is configured to acquire a first voltage of the first battery and a second voltage of the second battery from the voltage sensor and control the switch based on the first voltage and the second voltage.

2. The battery system of claim 1, wherein the battery management apparatus is configured to close the switch when a voltage difference between the first voltage and the second voltage is less than or equal to a threshold value.

3. The battery system of claim 1, wherein the battery management apparatus is configured to open the switch when the voltage difference between the first voltage and the second voltage is greater than the threshold value.

4. The battery system of claim 1, wherein the DC-DC converter is a 4-switch buck boost converter.

5. The battery system of claim 4, wherein the DC-DC converter comprises a first switching element, a second switching element, a third switching element, a fourth switching element, and an inductor,
wherein the first switching element is configured to selectively connect a positive electrode of the first battery to the second switching element and the inductor,
wherein the second switching element is configured to selectively connect the first switching element and the inductor to a negative electrode of the first battery,
wherein the third switching element is configured to selectively connect the fourth switching element and the inductor to a negative electrode of the second battery, and
wherein the fourth switching element is configured to selectively connect a positive electrode of the second battery to the third switching element and the inductor.

6. The battery system of claim 1, wherein the first battery and the second battery are battery cells, battery modules, battery packs, or battery racks.

7. The battery system of claim 1, wherein the first battery and the second battery are made of different components and have different chemical properties.

8. A method of using a battery system to control a switch, , the method comprising:
acquiring a first voltage of a first battery and a second voltage of a second battery, the second battery being connected to the first battery in parallel; and
controlling, based on the first voltage and the second voltage, a switch that is connected to a DC-DC converter in parallel between the first battery and the second battery and that is selectively opened and closed,
wherein the DC-DC converter is configured to be electrically connected between the first battery and the second battery and convert output power of at least one of the first battery and the second battery.

9. The method of claim 8, wherein the controlling of the switch comprises closing the switch when a voltage difference between the first voltage and the second voltage is less than or equal to a threshold value.

10. The method of claim 8, wherein the controlling of the switch comprises opening the switch when the voltage difference between the first voltage and the second voltage is greater than the threshold value.

11. The method of claim 8, wherein the DC-DC converter is a 4-switch buck boost converter.

12. The method of claim 11, wherein the DC-DC converter comprises a first switching element, a second switching element, a third switching element, a fourth switching element, and an inductor,
wherein the first switching element is configured to selectively connect a positive electrode of the first battery to the second switching element and the inductor,
wherein the second switching element is configured to selectively connect the first switching element and the inductor to a negative electrode of the first battery,
wherein the third switching element is configured to selectively connect the fourth switching element and the inductor to a negative electrode of the second battery, and
wherein the fourth switching element is configured to selectively connect a positive electrode of the second battery to the third switching element and the inductor.

13. The method of claim 8, wherein the first battery and the second battery are battery cells, battery modules, battery packs, or battery racks.

14. The method of claim 8, wherein the first battery and the second battery are made of different components and have different chemical properties.
